# EUROPÄISCHE PATENTSCHRIFT

(11) **EP 4 600 669 B1**
(45) Veröffentlichungstag und Bekanntmachung des Hinweises auf die Patenterteilung: **31.12.2025**
(21) Anmeldenummer: 24157203.1
(22) Anmeldetag: 12.02.2024
(51) Int. Cl.: G01R 29/08, G01R 31/00

(54) **SYSTEM UND VERFAHREN ZUR IDENTIFIKATION EINER URSACHE EINER ELEKTROMAGNETISCHEN STÖRUNG**
SYSTEM AND METHOD FOR IDENTIFYING A CAUSE OF AN ELECTROMAGNETIC DISTURBANCE
SYSTÈME ET PROCÉDÉ D'IDENTIFICATION D'UNE CAUSE D'UNE PERTURBATION ÉLECTROMAGNÉTIQUE

(43) Veröffentlichungstag der Anmeldung: 13.08.2025
(73) Patentinhaber: J. Schmitz GmbH, 83022 Rosenheim (DE)
(72) Erfinder: Schmitz, Josef, 83022 Rosenheim (DE)
(74) Vertreter: Flach Bauer & Partner Patentanwälte mbB

(56) Entgegenhaltungen:
- EP-B1- 1 695 425
- EP-B1- 1 736 788
- US-A1- 2010 125 438
- US-A1- 2014 256 375

## Beschreibung

### Gebiet der Erfindung

Die Erfindung betrifft ein System und ein Verfahren zur Identifikation einer Ursache einer elektromagnetischen Störung in einer elektrisch betriebenen Einrichtung. Zudem betrifft die Erfindung ein entsprechendes Computerprogramm.

### Hintergrund

In elektrisch betriebenen Einrichtungen wie Maschinen, Anlagen (insbesondere Industrieanlagen), Fahrzeugen oder Fahrzeugkomponenten), Luftfahrzeugen oder Luftfahrzeugkomponenten, medizinischen Gerätschaften, Energie- und Stromversorgungseinrichtungen, und/oder dergleichen kann es zu elektromagnetischen Störungen kommen.

Diese Störungen können die Einrichtung sowie Komponenten der Einrichtung in ihrer Funktion beeinträchtigen oder sogar beschädigen. Beispielshafte Komponenten sind Energiezuleitungen, Datenleitungen, Frequenzumrichter, Antriebe, und/oder dergleichen.

Zudem kann eine elektromagnetische Störungen ihre Ursache in einer verschlissenen oder defekten Komponente der elektrisch betriebene Einrichtung haben.

Da elektrisch betriebene Einrichtung oftmals sicherheitsrelevant sind (beispielsweise in der Luftfahrt) und/oder bei einem (Teil-)Ausfall hohe Kosten verursachen (beispielsweise wenn eine Industrieanlage steht) ist es wünschenswert elektromagnetische Störungen und vorzugsweise auch ihre Ursache frühzeitig zu erkennen.

Beispielsweise ist aus EP 1 736 788 A2 eine Vorrichtung zur Suche einer elektromagnetischen Störquelle bekannt. Hierbei werden Spannungen und Ströme in Kabeln zu einem zu überwachenden Gerät in der Zeitdomäne gemessen und in die Frequenzdomäne gewandelt. Darauf basierend wird die frequenzabhängige Energie berechnet, auf Basis derer die Einfallsrichtung der elektromagnetischen Interferenz bestimmt wird. Eine objektive Bestimmung wird somit ermöglicht, welche selbst von unqualifizierten Benutzern anwendbar ist. Weiterhin betrifft US 2010/125 438 A1 ein Verfahren zum Bestimmen des Energiepegels eines elektromagnetischen Feldes EMF, das von einer EMF-Quelle empfangen wird und EP 1 695 425 A1 schlägt ein Verfahren zur Erkennung einer breitbandigen Rauschquelle in einem Gleichspannungs-Verteilungsnetz vor.

Die hierfür nötigen Messungen sind sehr teuer und komplex, so dass diese nur durch speziell geschulte Experten durchführ- und auswertbar sind. Oftmals ist aufgrund der Komplexität eine sinnvolle Auswertung nicht möglich.

Daher werden oftmals Komponenten in eng vorgegebenen Abständen getauscht, um sicherzugehen, dass kein Versagen auftritt. Auch hierdurch entstehen hohe Kosten.

### Beschreibung der Erfindung

Vor diesem Hintergrund liegt der Erfindung die Aufgabe zugrunde Ursachen für elektromagnetische Störungen zu identifizieren. Dies soll auf möglichst einfache Art erfolgen. Die Identifikation der Ursache erlaubt zudem, die Ursache abzustellen (beispielsweise durch Tausch oder Reparatur einer Komponente) und somit einen Ausfall und/oder eine Beschädigung der elektrisch betriebenen Einrichtung und/oder weiterer Komponenten zu vermeiden.

Weiterhin hat sich überraschend gezeigt, dass von der Ursache der elektromagnetischen Störung bzw. der Art der Störung selbst auf den Zustand der elektrisch betriebenen Einrichtung bzw. deren Komponenten geschlossen werden kann. Dies ermöglicht nicht nur die rechtzeitige Beseitigung einer Störungsursache, sondern auch die Vorgabe von Wartungsintervallen und/oder Tauschempfehlungen von degradierten, beschädigten oder möglicherweise beschädigten Komponenten.

Das Risiko des Versagens von funktionswesentlichen Komponenten und/oder das Risiko von unerwarteten Stillstandzeiten der elektrisch betriebenen Einrichtung können mithin signifikant reduziert werden.

Die Aufgabe wird erfindungsgemäß durch ein System zur Identifikation einer Ursache einer elektromagnetischen Störung und durch ein entsprechendes Verfahren gelöst. Weitere Aspekte der Erfindung sind in den abhängigen Ansprüchen, sowie in der nachfolgenden Beschreibung beschrieben.

Insbesondere wird die Aufgabe durch ein System zur Identifikation einer Ursache einer elektromagnetischen Störung in einer elektrisch betriebenen Einrichtung gelöst. Das System kann in Software und/oder Hardware ausgeführt sein. Zudem können die einzelnen Systemkomponenten, wie eine optionale Bereichsfiltervorrichtung, eine Bewertungsfiltervorrichtung, eine Marker-Bestimmungsvorrichtung, eine Störungsidentifikationsvorrichtung und/oder eine optionale Peak-Detektor-Vorrichtung in Software und/oder Hardware ausgeführt sein.

In einer Ausführungsform des Systems umfassen die optionale Bereichsfiltervorrichtung, die Bewertungsfiltervorrichtung und die Marker-Bestimmungsvorrichtung Hardware-Komponenten (und optional Software), während die Störungsidentifikationsvorrichtung ausschließlich in Software ausgeführt ist. Es versteht sich, dass diese Software auf üblicher Hardware, wie beispielsweise einem PC, einem Laptop, einem Tablet, einem Smartphone, oder in der Cloud ausgeführt werden kann.

In einer anderen Ausführungsform ist beispielsweise auch die Bereichsfiltervorrichtung, die Bewertungsfiltervorrichtung und/oder die Marker-Bestimmungsvorrichtung rein in Software ausgeführt.

Weiterhin kann das System (wie auch die einzelnen Komponenten) ein zentrales System oder ein örtlich verteiltes System sein. Einzelne Komponenten oder Teile von Komponenten können also an unterschiedlichen Orten betrieben werden und als System zusammenwirken.

Die elektrisch betriebene Einrichtung kann eine Maschine, eine Anlage (insbesondere eine Industrieanlage), ein Fahrzeug oder eine Fahrzeugkomponente), ein Luftfahrzeug oder eine Luftfahrzeugkomponente, ein medizinisches Gerät, eine Energie- und Stromversorgungseinrichtungen, und/oder dergleichen sein.

Das System umfasst eine Bewertungsfiltervorrichtung, eine Marker-Bestimmungsvorrichtung und eine Störungsidentifikationsvorrichtung.

Die Bewertungsfiltervorrichtung umfasst einen Hochpassfilter, einen Bandpassfilter und/oder ein Tiefpassfilter und ist dazu eingerichtet, basierend auf einem elektromagnetischen Frequenzspektrum zumindest ein gefiltertes Frequenzspektrum zu erzeugen. Die Filter können in Hard- und/oder Software ausgeführt sein. Beispielsweise ist die Bewertungsfiltervorrichtung dazu eingerichtet ein hochpassgefiltertes elektromagnetisches Frequenzspektrum, ein bandpassgefiltertes elektromagnetisches Frequenzspektrum und/oder ein tiefpassgefiltertes elektromagnetisches Frequenzspektrum zu erzeugen. Das gefilterte Frequenzspektrum kann das gesamte erfasste Frequenzspektrum abdecken, oder nur Frequenzbereiche davon.

Das elektromagnetische Frequenzspektrum ist der elektrisch betriebenen Einrichtung zugeordnet und wird bzw. wurde vorzugsweise im normalen Arbeitsbetrieb der elektrisch betriebenen Einrichtung erfasst. Hierzu kann das System entsprechende Sensor(en) umfassen, oder dem System können Daten bereitgestellt werden, die dem elektromagnetischen Frequenzspektrum entsprechen, aber anderweitig (z.B. durch eine separate Messeinrichtung oder durch eine, der elektrisch betriebenen Einrichtung immanenten Messeinrichtung) erfasst wurden.

Die Marker-Bestimmungsvorrichtung ist dazu eingerichtet, zumindest für das gefilterte Frequenzspektrum einen Markerkennwert zu bestimmen. Der Markerkennwert ist ein Maß für den Energiegehalt des gefilterten, elektromagnetischen Frequenzspektrums. Erfindungsgemäß wird der Markerkennwert durch eine logarithmische Addition, von Einzelwerten bestimmt. Die Einzelwerte können dabei den (gefilterten) Messwerten entsprechen, die bei der Erfassung des Frequenzspektrums erfasst wurden.

Beispielsweise kann die Marker-Bestimmungsvorrichtung je einen Markerkennwert für jedes gefilterte Frequenzspektrum und optional einen weiteren für das ungefilterte Frequenzspektrum (bzw. einen Frequenzbereich davon) selbst bestimmen. Für das Frequenzspektrum können also mehrere Markerkennwerte bestimmt werden (z.B. PE_{Hochpass}, PE_{Bandpass}, PE_{Tiefpass}, PE_{ungefiltert}).

Der Markerkennwert PE_{Hochpass} wird durch die logarithmische Addition von Einzelwerten des hochpassgefilterten Frequenzspektrums bzw. eines hochpassgefilterten Frequenzbereichs (Teil- Frequenzspektrum) bestimmt. Entsprechend wird der Markerkennwert PE_{Bandpass} durch die logarithmische Addition von Einzelwerten des bandpassgefilterten Frequenzspektrums bzw. eines bandpassgefilterten Frequenzbereichs (Teil-Frequenzspektrum) bestimmt und der Markerkennwert PE_{Tiefpass} kann durch die logarithmische Addition von Einzelwerten des tiefpassgefilterten Frequenzspektrums bzw. eines tiefpassgefilterten Frequenzbereichs (Teil-Frequenzspektrum) bestimmt werden. Der Markerkennwert PE_{ungefiltert} bestimmt sich in analoger weise durch die logarithmische Addition von Einzelwerten des ungefilterten Frequenzspektrums bzw. Frequenzbereichs (Teil-Frequenzspektrum).

Durch die Bestimmung der Markerkennwerte ist eine aufwendige und oft komplexe Auswertung eines Graphs des Frequenzspektrums nicht nötig, sodass auch ungelernte Kräfte anstelle von Spezialisten das System nutzen können.

Die Störungsidentifikationsvorrichtung ist schließlich dazu eingerichtet, den zumindest einen bestimmten Markerkennwert mit einem zugeordneten Referenz-Markerkennwert (PE_{ref}; bzw. PE_{Hochpass,ref}, PE_{Bandpass,ref}, PE_{Tief-pass,ref}, PE_{ungefiltert,ref}) zu vergleichen und basierend auf einem Vergleichsergebnis eine Ursache einer elektromagnetischen Störung zu identifizieren.

Da die Markerkennwerte ein Maß für den Energiegehalt des (gefilterten) Frequenzspektrums bzw. eines (gefilterten) Frequenzbereichs entsprechen, ändern sich die Markerkennwerte mit einer Veränderung des Frequenzspektrums. Durch die Filterung bzw. die bereichsweise Betrachtung, kann die Art der Veränderung des Frequenzspektrums und damit einer auftretenden Störung charakterisiert werden.

Steigt beispielsweise die Amplitude des Frequenzspektrums in einem unteren Frequenzbereich an, steigt der Markerkennwert für das ungefilterte Frequenzspektrum sowie der Markerkennwert für das tiefpassgefilterte Frequenzspektrum. Die Markerkennwerte für das bandbassgefilterte und hochpassgefilterte Frequenzspektrum bleiben hingegen gleich. Ein solcher Anstieg kann auf eine höhere Last hindeuten. Wird die Einrichtung nicht unter einer höheren Last betrieben, kann dies auf eine erhöhte Reibung und mithin auf einen möglichen Verschleiß hindeuten.

Durch die Bewertungsfiltervorrichtung können auch schmalbandige, minimale Störphänomene (z.B. < 6dB) in einem breitbandigen abfallenden oder ansteigenden Frequenzspektrum (insbesondere Amplitudenspektrum) erfasst werden. Bei einer globalen, ungefilterten Betrachtung würden solche schmalbandigen, minimalen Störphänomene nicht erfasst. Die Hoch-, Tief- und/oder Bandpassfilterung macht diese schmalbandigen, minimalen Störphänomene hingegen in den Markerkennwerten sichtbar.

Durch eine geeignete Wahl der Filter der Bewertungsfiltervorrichtung können mithin elektromagnetische Störungen auf bestimmte Frequenzen eingegrenzt und voneinander unterschieden werden.

Insbesondere kann das Vergleichsergebnis charakteristisch für eine Ursache einer elektromagnetischen Störung sein. Um die Ursache der Störung zu bestimmen, kann einer Störung ein charakteristisches Vergleichsergebnis zugeordnet sein (beispielsweise in einer Datenbank). Ebenso ist es möglich, das Vergleichsergebnis mittels einer KI analysieren zulassen, um die Ursache einer Störung zu bestimmen. Die KI kann eine selbstlernende KI sein, deren Datenbasis u.a. bekannte Störungen und charakteristische Vergleichsergebnisse bilden.

Die charakteristischen Vergleichsergebnisse bzw. die Datenbasis der KI kann beispielsweise auf zumindest einem der folgenden basieren:
- EMV-Datenblättern der elektrisch betriebenen Einrichtung und/oder deren Komponenten
- Messungen/Simulationen von Markerkennwerten und/oder Frequenzspektren bei der Inbetriebnahme und/oder vorangegangenen Wartungen
- Spezifische Degradationsverlaufs-Kurven der elektrisch betriebenen Einrichtung und/oder deren Komponenten, welche die Veränderung des elektromagnetischen Verhaltens angeben, in Abhängigkeit der Betriebsdauer und/oder eines Alterungsprozesses
- Vorsorge Grenzwerte, insbesondere für eine interne Entkopplung von elektromagnetischen Phänomenen, vorzugsweise mit Wirkungs-Nachweis durch Messungen
- Spezifische Relationen von unterschiedlichen Markerkennwerten für bekannte elektromagnetische Phänomene/Störungen

Die Vorgenannten können durch Messung und/oder Simulation erhalten worden sein.

Ebenso kann es möglich sein, aus dem Vergleichsergebnis die künftige Entwicklung der elektrisch betriebenen Einrichtung zu prognostizieren. Basierend auf dieser Prognose kann dann beispielsweise ein Wartungsintervall festgelegt werden, oder eine Empfehlung für den Tausch einer Komponente (oder eines Bauteils), welche als Störquelle identifiziert wurde, ausgesprochen werden, bevor diese versagt. Insbesondere kann auch ein zeitlicher Degradationsverlauf für einzelne Komponenten bestimmt werden, welcher dann für die Bestimmung des Wartungsintervalls oder eines Zeitpunkts für den Tausch/die Instandsetzung der Komponente herangezogen werden kann.

Zudem ist es möglich, das elektromagnetische Frequenzspektrum nach Instandsetzungsmaßnahmen und/oder Veränderungen an der der elektrisch betriebenen Einrichtung zu erfassen. Das Vergleichsergebnis kann sodann als Beleg genutzt werden, nachzuwiesen, dass die Instandsetzung erfolgreich und/oder die Veränderung keine wesentliche Beeinträchtigung der elektromagnetischen Eigenschaften der elektrisch betriebenen Einrichtung (insbesondere der Störaussendung) bewirkt.

Da das System Anstelle von komplexen Frequenzverläufen Markerkennwerte ausgibt, ist es zudem einfach zu bedienen.

Weiterhin umfasst das System zumindest einen Sensor. Der Sensor (oder eine Vielzahl von Sensoren) dient zur Erfassung des elektromagnetischen Frequenzspektrums. Der zumindest eine Sensor kann ein H-Feld Sensor (beispielsweise ein Hall-Sensor, ein Magnetoresistiver-Sensor, ein Fluxgate-Sensor und/oder dergleichen), ein Stromsensor, und/oder ein Spannungssensor sein, bzw. einen solchen umfassen. Sind mehrere Sensoren vorgesehen, können unterschiedliche Sensortypen zur Erfassung des elektromagnetischen Frequenzspektrums eingesetzt sein.

Die Sensoren können fest in der elektrisch betriebenen Einrichtung installiert sein. Dies ist vorteilhaft, da so sichergestellt ist, dass immer an der gleichen Stelle gemessen wird. Ebenso ist es möglich, dass die Sensoren portabel sind und zur Erfassung des elektromagnetischen Frequenzspektrums an entsprechenden Messpunkten angeordnet werden.

Insbesondere können die Sensoren unterschiedlichen, definierten Messpunkten der elektrisch betriebenen Einrichtung zugeordnet sein. Somit kann für jeden Messpunkt zumindest ein spezifisches Frequenzspektrum zu erfasst werden. Ein Messpunkt kann zum Beispiel einer elektrischen Leitung zugeordnet sein und ein Frequenzspektrum eines Schirmstroms erfassen. Ein anderer Messpunkt kann zum Beispiel einem Frequenzumrichter und/oder einer anderen Komponente der elektrisch betriebenen Einrichtung zugeordnet sein und ein entsprechender Sensor kann dort das H-Feld (insbesondere das magnetische Nahfeld) erfassen. Ein weiterer Messpunkt kann beispielsweise an einem Massepunkt der elektrisch betriebenen Einrichtung angeordnet sein und ein entsprechender Sensor kann dort eine Spannung, insbesondere eine Störspannung, erfassen.

Um die Lage der Massepunkte ideal zu bestimmen, kann die elektrisch betriebenen Einrichtung in unterschiedliche Bereiche unterteilt werden, wobei den Bereichen eine unterschiedliche Störrelevanz zugeordnet werden kann. Bereiche mit hoher Störrelevanz und/oder mit kritischen Komponenten können beispielsweise eine höhere Messpunktdichte aufweisen, als Bereiche mit niedriger Störrelevanz und/oder ohne kritische Komponenten. In analoger Weise können elektrische Leitungen der elektrisch betriebenen Einrichtung in unterschiedliche Leitungsklassen eingeteilt werden.

In einem weiteren Aspekt der Erfindung sind der elektrisch betriebenen Einrichtung mehrere definierte Messpunkte zugeordnet. Ein erster Messpunkt (oder ein erstes Set von Messpunkten, d.h. zumindest zwei Messpunkte) kann einer ersten Komponente der elektrisch betriebenen Einrichtung und ein zweiter Messpunkt (oder ein zweites Set von Messpunkten, d.h. zumindest zwei Messpunkte) kann einer zweiten Komponente der elektrisch betriebenen Einrichtung zugeordnet sein, die von der ersten Komponente verschieden ist.

Beispielsweise umfasst die erste und die zweite Komponente je einen Massepunkt und eine Versorgungsleitung, denen jeweils ein definierter Messpunkt zugeordnet ist. Ein weiterer Messpunkt kann beispielsweise für die Messung eines Nahfelds (H-Feld) an geeigneter Stelle vorgesehen sein.

Die Störungsidentifikationsvorrichtung kann Informationen umfassen, oder auf Informationen zugreifen können, die bestehende (galvanische) Beeinflussungspfade zwischen unterschiedlichen, definierten Messpunkten, die der elektrisch betriebenen Einrichtung zugeordnet sind, beschreiben.

An jedem der Messpunkte kann nun ein Frequenzspektrum erfasst werden. Jedes Frequenzspektrum kann dann in Frequenzbereiche unterteilt (beispielsweise mittels einer Bereichsfiltervorrichtung) und tiefpass-, hochpass- und bandpassgefiltert werden (mittels der Bewertungsfiltervorrichtung). Anschließend können entsprechende Markerkennwerte für jeden Messpunkt bestimmt - und basierend auf der Information zu den bestehenden (galvanischen) Beeinflussungspfaden - zueinander in Relation gesetzt werden. Zudem können die bestimmten Markerkennwerte mit Referenz-Markerkennwerten und/oder einem Degradationsmodell verglichen werden.

Aus den Vergleichsergebnissen und der Information zu den bestehenden (galvanischen) Beeinflussungspfaden kann dann eine Ursache einer Störung bestimmt werden. Zudem erlaubt die Information zu den bestehenden (galvanischen) Beeinflussungspfaden etwaige unterwünschte elektromagnetische Kopplungen zu detektieren und anschließend zu beheben, bzw. auf eine detektierte unterwünschte elektromagnetische Kopplung hinzuweisen.

Wird beispielsweise eine elektromagnetische Störung in einem H-Feld einer ersten Komponente und der Versorgungsleitung dieser ersten Komponente detektiert (über die Frequenzspektren der entsprechenden Messpunkte), und zudem in einer Versorgungsleitung einer zweiten Komponente, und ist bekannt, dass sich die beiden Leitungen beeinflussen können (weil sie beispielsweise bereichsweise parallel verlegt sind), kann auf eine unterwünschet Kopplung dieser beiden Versorgungsleitungen geschlossen werden, wobei die Störung von der ersten Komponente ausgeht.In einem weiteren Aspekt umfasst das erfasste elektromagnetische Frequenzspektrum zumindest einen Frequenzbereich von 5 kHz bis 15 MHz, oder von 10 kHz bis 10 MHz oder von 12 kHz bis 8 MHz. Es hat sich gezeigt, dass dieser Frequenzbereich für die Identifikation von Störungsursachen ideal ist.

Das erfasste elektromagnetische Frequenzspektrum kann zumindest zwei Frequenzbereiche umfassen. Für diese separaten Frequenzbereiche kann jeweils ein Teil-Frequenzspektrum erfasst werden (mittels entsprechender Sensoren), welche Teil-Frequenzspektren dann das Frequenzspektrum ergeben. Ebenso ist es möglich, dass ein erfasstes Frequenzspektrum mittels einer Bereichsfiltervorrichtung in entsprechende Frequenzbereiche (bzw. Teil-Frequenzspektren) aufgeteilt wird.

Die Bewertungsfiltervorrichtung kann ferner dazu eingerichtet sein, für die zumindest zwei Frequenzbereiche (Teil- Frequenzspektrum) jeweils zumindest ein gefiltertes Bereichs-Frequenzspektrum erzeugen. Beispielsweise kann jeder Frequenzbereich hochpassgefiltert, bandpassgefiltert und/oder tiefpassgefiltert werden.

Die Marker-Bestimmungsvorrichtung kann entsprechend dazu eingerichtet sein für das erfasste Frequenzspektrum, die Frequenzbereiche (bzw. Teil-Frequenzspektren) und/oder die gefilterten Bereichs-Frequenzspektren je einen Markerkennwert zu bestimmen. Somit kann eine Vielzahl von Markerkennwerten bestimmt werden.

Wird ein Frequenzspektrum beispielsweise mittels einer Bereichsfiltervorrichtung in zwei Frequenzbereiche unterteilt und wird jeder Frequenzbereich nochmals hochpassgefiltert, bandpassgefiltert und tiefpassgefiltert, können für das Frequenzspektrum beispielsweise acht Markerkennwerte bestimmt werden (je ein Markerkennwert für den Frequenzbereich, und je ein Markerkennwert für die hochpassgefilterten, bandpassgefilterten und/oder tiefpassgefilterten Frequenzbereiche). Wird das Frequenzspektrum in mehrere Frequenzbereiche unterteilt und/oder werden beispielsweise mehrere Bandfilter eingesetzt, erhöht sich die Zahl der bestimmbaren Markerkennwerte entsprechend. Je mehr Markerkennwerte bestimmt werden, desto mehr unterschiedliche Ursachen können unterschieden werden.

Es hat sich gezeigt, dass eine Unterteilung des Frequenzspektrums in drei Frequenzbereiche, die einen Frequenzbereich von zumindest 10 kHz bis zumindest 100 kHz, und einen Frequenzbereich von zumindest 100 kHz bis zumindest 1 MHz, und einen Frequenzbereich von zumindest 1 MHz bis zumindest 10 MHz umfassen, zu guten Ergebnissen bei der Identifikation von Ursachen von elektromagnetischen Störungen führt. Je nach Anwendungsfall kann eine andere Art der Unterteilung erfolgen.

Der Markerkennwert wird durch eine logarithmische Addition von Einzelwerten bestimmt. Die Einzelwerte bilden zusammen das erfasste Frequenzspektrum, ein gefiltertes Frequenzspektrum, einen Frequenzbereich, oder ein gefiltertes Bereichs-Frequenzspektrum, je nachdem, welcher Markerkennwert bestimmt wird.

Die logarithmische Addition bezeichnet dabei die Addition der Einzelwerte im logarithmischen Raum. Hierzu werden beispielsweise die Logarithmen der Einzelwerte addiert. Die Summe kann anschließend in eine normale Zahl zurückgewandelt werden, um den Markerkennwert zu erhalten.

Bei der Erfassung des Frequenzspektrums kann der zumindest eine Sensor in einem ersten Frequenzbereich eine erste Messbandbreite aufweisen und in einem zweiten Frequenzbereich eine zweite Messbandbreite, wobei der erste Frequenzbereich unter dem zweiten Frequenzbereich liegt, und wobei die erste Messbandbreite geringer ist als die zweite Messbandbreite.

Das System kann weiterhin eine Peak-Detektor-Vorrichtung umfassen. Die die Peak-Detektor-Vorrichtung ist dazu eingerichtet, Peaks, insbesondere zeitlich floatenden Peaks und/oder Burst-Peaks, im erfassten Frequenzspektrum zu ermitteln. Die Störungsidentifikationsvorrichtung kann dazu eingerichtet sein, die ermittelten Peaks bei der Identifikation der Ursache der elektromagnetischen Störung zu berücksichtigen. Regelmäßige Peaks können beispielsweise einer Taktfrequenz einer Industrieanlage entsprechen. Treten hier Änderungen gegenüber einem Referenzwert auf, kann dies erkannt und die Ursache für die Abweichung identifiziert werden. Zeitlich floatenden Peaks können zeitlich variierenden Belastungen der elektrisch betriebenen Vorrichtung entsprechen, wie beispielsweise einem Anfahren einer Industrieanlage und/oder einer zeitlich begrenzten höheren (oder niedrigeren) Last oder Auslastung. Abweichungen in den zeitlich floatenden Peaks von einem Referenzwert kann auf eine erhöhte Reibung in der elektrisch betriebenen Einrichtung und mithin auf Verschleiß hindeuten.

In einem Aspekt der Erfindung kann die Störungsidentifikationsvorrichtung dazu eingerichtet sein, die bestimmten Markerkennwerte mit entsprechenden zugeordneten Referenz-Markerkennwerten zu vergleichen und basierend auf dem Vergleich eine Abweichungscharakteristik zu erstellen. Die Abweichungscharakteristik kann die Abweichungen einzelner Markerkennwerte von zugeordneten Referenz-Markerkennwerten in Relation setzen. Die Abweichungscharakteristik kann auch Abweichungen von ermittelten Peaks umfassen. Somit können Abweichungen von einzelnen Markerkennwerten und/oder Peaks zueinander in Relation gesetzt werden.

Die Störungsidentifikationsvorrichtung kann dann dazu eingerichtet sein, basierend auf der Abweichungscharakteristik eine Ursache der elektromagnetischen Störung zu identifizieren und/oder eine Störaussendungsprognose zu erstellen. Da die Abweichungen von einzelnen Markerkennwerten und/oder Peaks zueinander in Relation gesetzt werden, können Ursachen genauer bestimmt werden, als die bei einem bloßen 1:1 Vergleich der einzelnen Markerkennwerte mit ihrem entsprechenden Referenz-Markerkennwert möglich wäre.

Zeigt die Abweichungscharakteristik eine nur geringe Gesamtabweichung (Beispielsweise nach Änderungen oder Instandsetzungen der elektrisch betriebenen Einrichtung), so kann darauf geschlossen werden, dass die erforderlichen Vorsorge-Grenzwerte, insbesondere die Störaussendungs-Grenzwerte weiterhin eingehalten werden.

In einem weiteren Aspekt kann die Störungsidentifikationsvorrichtung dazu eingerichtet sein, die bestimmten Markerkennwerte und/oder eine Abweichungscharakteristik mit einem Degradationsmodell, welches der elektrisch betriebenen Einrichtung zugeordnet ist, zu vergleichen und basierend auf dem Vergleich ein empfohlenes Wartungsintervall und/oder eine Komponententauschempfehlung auszugeben.

Das Degradationsmodell kann auf realen Messungen und/oder auf einer Simulation beruhen. Dabei kann für die elektrisch betriebene Einrichtung ein globales Degradationsmodell erstellt werden. Ebenso ist es möglich, für jeden Messpunkt und/oder jede Komponente ein separates (Sub-) Degradationsmodell zu erstellen (durch Messung und/oder Simulation). Die Sub- Degradationsmodelle können dann zu einem globalen Degradationsmodell kombiniert werden. So ist es möglich das Degradationsmodell anzupassen, wenn eine Komponente und/oder ein Messpunkt verändert wird. Insbesondere kann das Degradationsmodell (entsprechend die Sub- Degradationsmodelle) Degradationsverlaufskurven umfassen, die eine prognostizierte (oder gemessene) zeitliche Veränderung der Markerkennwerte und/oder Peaks abbilden.

Weiterhin kann das Degradationsmodell auf zumindest einem der folgenden basieren:
- EMV-Datenblättern der elektrisch betriebenen Einrichtung und/oder deren Komponenten
- Messungen/Simulationen von Markerkennwerten und/oder Frequenzspektren bei der Inbetriebnahme und/oder vorangegangenen Wartungen
- Spezifische Degradationsverlaufs-Kurven der elektrisch betriebenen Einrichtung und/oder deren Komponenten, welche die Veränderung des elektromagnetischen Verhaltens angeben, in Abhängigkeit der Betriebsdauer und/oder eines Alterungsprozesses
- Vorsorge-Grenzwerte, insbesondere für eine interne Entkopplung von elektromagnetischen Phänomenen, vorzugsweise mit Wirkungs-Nachweis durch Messungen
- Spezifische Relationen von unterschiedlichen Markerkennwerten für bekannte elektromagnetische Phänomene/Störungen
- Informationen zu bestehenden (galvanischen) Beeinflussungspfaden unterschiedlicher, definierter Messpunkte, die der elektrisch betriebenen Einrichtung zugeordnet sind.

Ergibt der Vergleich mit dem Degradationsmodell eine geringe Gesamtabweichung von einem Initialzustand, kann ein längeres empfohlenes Wartungsintervall angegeben werden. Entsprechend kann bei einer hohen, oder bereichsweise hohen Abweichung ein kürzeres Wartungsintervall angesagt sein kann. Wird ein Vorsorge-Grenzwert überschritten oder ist kurz davor überschritten zu werden, kann eine störungsaussendende Komponente getauscht und/oder Instandgesetzt werden. Zudem ist es möglich Komponenten zu tauschen und/oder instand zu setzen, die durch die Störaussendung möglicherweise geschädigt werden. Hierzu kann eine stochastische Wahrscheinlichkeit bestimmt werden, ob eine Komponente durch die Störaussendung geschädigt wurde.

Für unterschiedliche Komponenten können, soweit die Abweichungen diesen Komponenten zugeordnet werden können, unterschiedliche Wartungsintervalle und/oder Tauschempfehlungen ausgegeben werden. Somit können Komponenten getauscht oder Instand gesetzt werden, bevor es zu einem Versagen und mithin zu einer Gefährdung und/oder langen Stillstandzeiten kommt.

Weiterhin wir die Aufgabe durch ein Verfahren zur Identifikation einer Ursache einer elektromagnetischen Störung in einer elektrisch betriebenen Einrichtung gelöst. Das Verfahren kann mit einem zuvor beschriebenen System ausgeführt werden. Insbesondere kann das Verfahren alle oder einige der Verfahrensschritte umfassen, die oben beschrieben wurden und zu denen die einzelnen Systemkomponenten, wie die optionale Bereichsfiltervorrichtung, die Bewertungsfiltervorrichtung, die Marker-Bestimmungsvorrichtung, die Störungsidentifikationsvorrichtung und/oder die optionale Peak-Detektor-Vorrichtung eingerichtet sind.

Ist das obige System in Software implementiert kann das Verfahren ein computerimplementiertes Verfahren sein.

Das erfindungsgemäße Verfahren umfasst zumindest folgendes:
- Optional Bereitstellen eines erfassten elektromagnetischen Frequenzspektrums, welches der elektrisch betriebenen Einrichtung zugeordnet ist;
- Filtern des elektromagnetischen Frequenzspektrums und/oder eines Frequenzbereichs, mittels einer Bewertungsfiltervorrichtung, die einen Hochpassfilter, einen Bandpassfilter und/oder ein Tiefpassfilter umfasst, und Erzeugen zumindest eines gefilterten Frequenzspektrums und/oder eines gefilterten Bereichs-Frequenzspektrums;
- Bestimmen zumindest eines Markerkennwerts, welcher Markerkennwert ein Maß für den Energiegehalt des gefilterten, elektromagnetischen Frequenzspektrums und/oder eines gefilterten Bereichs-Frequenzspektrums und/oder eines Frequenzbereichs ist;
- Vergleichen des zumindest einen bestimmten Markerkennwerts mit einem zugeordneten Referenz-Markerkennwert, und
- Identifizieren, basierend auf dem Vergleichsergebnis, einer Ursache einer elektromagnetischen Störung.

Das Verfahren umfasst weiterhin einen Schritt (vorzugsweise vor dem Erzeugen zumindest eines gefilterten Frequenzspektrums), indem das Frequenzspektrum in zumindest zwei Frequenzbereiche unterteilt wird. Im Anschluss können dann gefilterte Frequenzbereiche bzw. Teil-Frequenzspektren erzeugt werden.

In einem Aspekt der Erfindung erfolgt das Erfassen eines elektromagnetischen Frequenzspektrums während des Betriebs der elektrisch betriebenen Einrichtung. Mithin repräsentieren die erfassten Frequenzspektren und die daraus bestimmten Markerkennwerte und/oder Peaks Störungen die im Betrieb der Einrichtung auftreten. Dies erlaubt eine genaue Identifikation von Ursachen etwaiger Störungen und mithin eine aktuelle, zerstörungsfreie Zustandsanalyse der elektrisch betriebenen Einrichtung.

Weiterhin wird die Aufgabe durch ein Computerprogramm gelöst, welches Anweisungen umfasst, die, wenn sie von zumindest einem Prozessor ausgeführt werden, den Prozessor dazu veranlassen zumindest das Vergleichen des zumindest einen bestimmten Markerkennwerts mit einem zugeordneten Referenz-Markerkennwert und das Identifizieren, basierend auf dem Vergleichsergebnis, einer Ursache einer elektromagnetischen Störung auszuführen, wobei die Anweisungen den Prozessor optional dazu veranlassen das zuvor beschriebene Verfahren auszuführen.

### Kurze Beschreibung der Figuren

Die Erfindung wird nachfolgend anhand der beigefügten Figuren beispielhaft näher erläutert. Es zeigen:
- Figur 1: eine schematische Darstellung eines Systems zur Identifikation einer Ursache einer elektromagnetischen Störung;
- Figur 2: eine schematische Darstellung eines weiteren Systems zur Identifikation einer Ursache einer elektromagnetischen Störung;
- Figur 3: eine schematische Darstellung von Markerkennwerten in einem Frequenzspektrum;
- Figur 4: eine schematische Darstellung einer Hochpass-, Tiefpass - und Bandpassfilterung;
- Figur 5: eine schematische Darstellung gefilterter Frequenzbereiche,
- Figur 6: eine schematische Darstellung einer elektrisch betriebenen Einrichtung, und
- Figur 7: ein schematisches Ablaufdiagramm eines erfindungsgemäßen Verfahrens.

### Beschreibung der Figuren

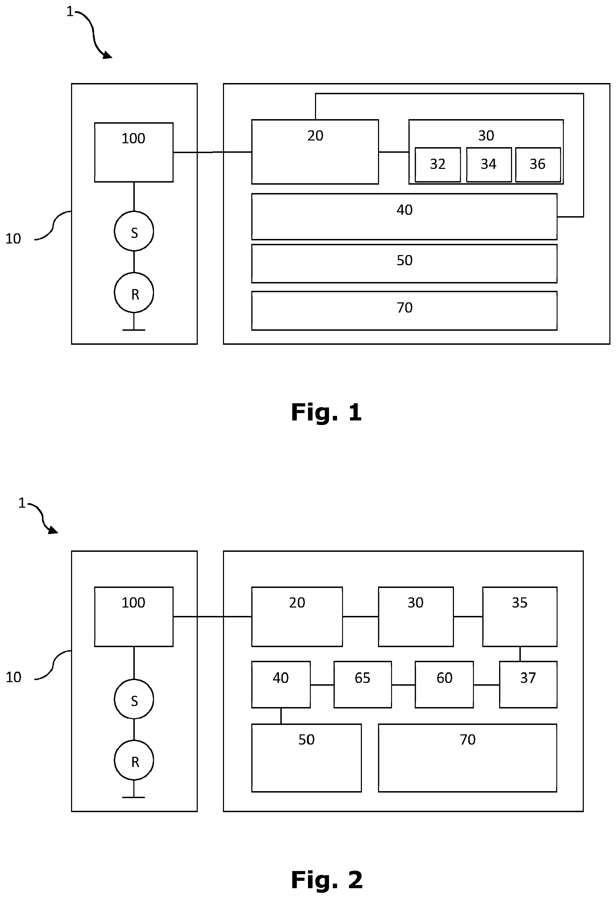

Figur 1 zeigt eine schematische Darstellung eines Systems 1 zur Identifikation einer Ursache einer elektromagnetischen Störung. Das gezeigte System 1 umfasst eine Bereichsfiltervorrichtung 20, welche zumindest ein von einem Sensor 10 erfasstes Frequenzspektrum 100 empfängt. Der Sensor 10 kann beispielsweise ein H-Feld Sensor, ein Stromsensor oder ein Spannungssensor sein. Das Frequenzspektrum 100 wird beispielsweise durch ein Signal S und durch Rauschen R gebildet. Zudem kann das Frequenzspektrum 100 beeinflusst und optional gestört sein. Typischerweise erfasst der Sensor ein Frequenzspektrum 100 von 10 kHz bis 10 MHz.

Die Bereichsfiltervorrichtung 20 ist dann dazu eingerichtet, das empfangene Frequenzspektrum in Frequenzbereiche zu unterteilen. Beispielsweise in einen ersten Frequenzbereich 110 von 10 kHz bis 100 kHz, einen zweiten Frequenzbereich 120 von 100 kHz bis 1 MHz, und in einen dritten Frequenzbereich 130 von 1 MHz bis 10 MHz.

Diese Frequenzbereiche werden dann von einer Bewertungsfiltervorrichtung 30 weiterverarbeitet. Die Bewertungsfiltervorrichtung 30 umfasst einen Hochpassfilter 32, einen Bandpassfilter 34 und ein Tiefpassfilter 36. Sie ist dazu eingerichtet das Frequenzspektrum vorzugsweise Bereichsweise zu filtern und so hochpass-, bandpass-, und tiefpass-gefilterte (Teil-)Frequenzspektren bzw. Frequenzbereiche zu erzeugen.

Die gefilterten Frequenzspektren können dann an eine Marker-Bestimmungsvorrichtung 40 übergeben werden. Ebenso können die ungefilterten Frequenzbereiche an die Marker-Bestimmungsvorrichtung 40 übergeben werden. Die Marker-Bestimmungsvorrichtung 40 kann sodann für die gefilterten (Teil-)Frequenzspektren je einen Markerkennwert PE bestimmen. Entsprechend können für die ungefilterten Frequenzbereiche Markerkennwerte bestimmt werden. Der Markerkennwert PE ist ein Maß für den Energiegehalt des jeweiligen (gefilterten) elektromagnetischen (Teil-)Frequenzspektrums.

Anschließend können die Markerkennwerte PE einer Störungsidentifikationsvorrichtung 50 übergeben werden. Die die Störungsidentifikationsvorrichtung vergleicht die Markerkennwerte PE mit entsprechenden Referenz-Markerkennwerten PE_{ref}. Basierend auf dem Vergleichsergebnis kann dann eine Ursache einer elektromagnetischen Störung identifiziert werden, denn es hat sich gezeigt, dass die Abweichung der Markerkennwerte charakteristisch für solche Störursachen ist.

Das Ergebnis, d.h. die Markerkennwerte und/oder die Ursache der Störung, sowie etwaige weitere Auswertungen, wie ein Wartungsintervall, eine zu Tauschende Komponente, ..., können sodann auf einem Display 70 angezeigt, an eine anderweitige Anzeigevorrichtung übermittelt oder gespeichert werden.

Figur 2 zeigt eine schematische Darstellung eines weiteren Systems zur Identifikation einer Ursache einer elektromagnetischen Störung. Dieses System entsprich im Wesentlichem dem in Figur 1 gezeigten System. Hier ist nach der Bewertungsfiltervorrichtung 30 ein Logarithmischer Verstärker angeordnet, welcher die gefilterten Frequenzspektren verstärken kann, bevor sie über eine optionale Treiberstufe 37 an eine Peak-Detektor-Vorrichtung 60 übergeben werden. Es versteht sich, dass die Peak-Detektor-Vorrichtung 60 auch an anderer Stelle im System angeordnet sein kann.

Die Peak-Detektor-Vorrichtung 60 ist dazu eingerichtet, Peaks, insbesondere zeitlich floatenden Peaks und/oder Burst-Peaks, im erfassten Frequenzspektrum 100 zu ermitteln. Diese können dann von der Störungsidentifikationsvorrichtung zur Identifikation der Ursache der elektromagnetischen Störung berücksichtigt werden.

Weiterhin kann das System einen A/D Wandler 65 umfassen. Dieser kann der Marker-Bestimmungsvorrichtung 40 und/oder der Störungsidentifikationsvorrichtung 50 vorgeschaltet sein, sodass die Filterung im analogen, die Markerkennwert-Bestimmung und der Vergleich in der digitalen Domäne stattfindet.

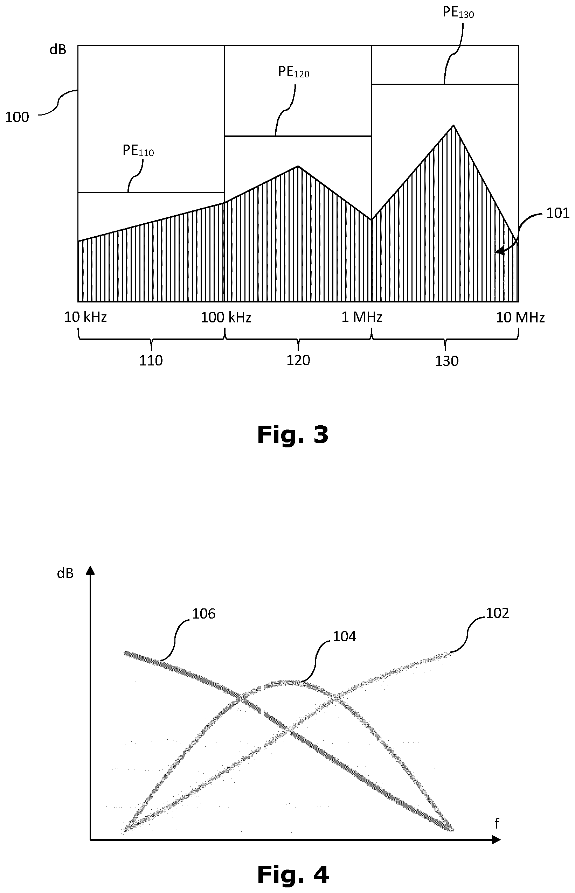

Figur 3 zeigt eine schematische Darstellung eines Frequenzspektrums 100. Das Frequenzspektrum wurde in drei Teil-Spektren bzw. Frequenzbereiche 110, 120, 130 unterteilt. Der ersten Frequenzbereich 110 reicht von 10 kHz bis 100 kHz, der zweite Frequenzbereich 120 von 100 kHz bis 1 MHz, und der dritte Frequenzbereich 130 von 1 MHz bis 10 MHz. Für jeden dieser Frequenzbereiche wurde sodann ein Markerkennwert ermittelt, hier mit PE₁₁₀, PE₁₂₀ und P₁₃₀ bezeichnet. Die Markerkennwerte können insbesondere durch logarithmische Addition der jeweiligen Einzelwerte 101 bestimmt werden.

Da diese Bereichs-Markerkennwerte in ihrem jeweiligen Frequenzbereich nicht frequenzselektiv sind, können schmalbandige, minimale Störphänomene (z.B. < 6dB) nicht zweifelsfrei erfasst werden.

Um die schmalbandige, minimale Störphänomene dennoch erfassen zu können, kann das Frequenzspektrum 100 und insbesondere die einzelnen Frequenzbereiche 110, 120, 130 nochmals mittels der Bewertungsfiltervorrichtung 30 gefiltert werden (d.h. hochpassgefiltert, bandpassgefiltert und tiefpassgefiltert).

Dies ist exemplarisch in Figur 4 gezeigt. Das Frequenzspektrum, bzw. ein Frequenzbereich wird gefiltert, und es wird ein hochpassgefiltertes Frequenzspektrum 102, ein bandpassgefiltertes Frequenzspektrum 104, und ein tiefpassgefiltertes Frequenzspektrum 106 erzeugt. Für jedes gefilterte Frequenzspektrum/Frequenzbereich können dann wiederum entsprechende Markerkennwerte bestimmt werden und für den Vergleich und die Ursachenidentifikation herangezogen werden. Somit können auch schmalbandige, minimale Störphänomene erfasst und berücksichtigt werden.

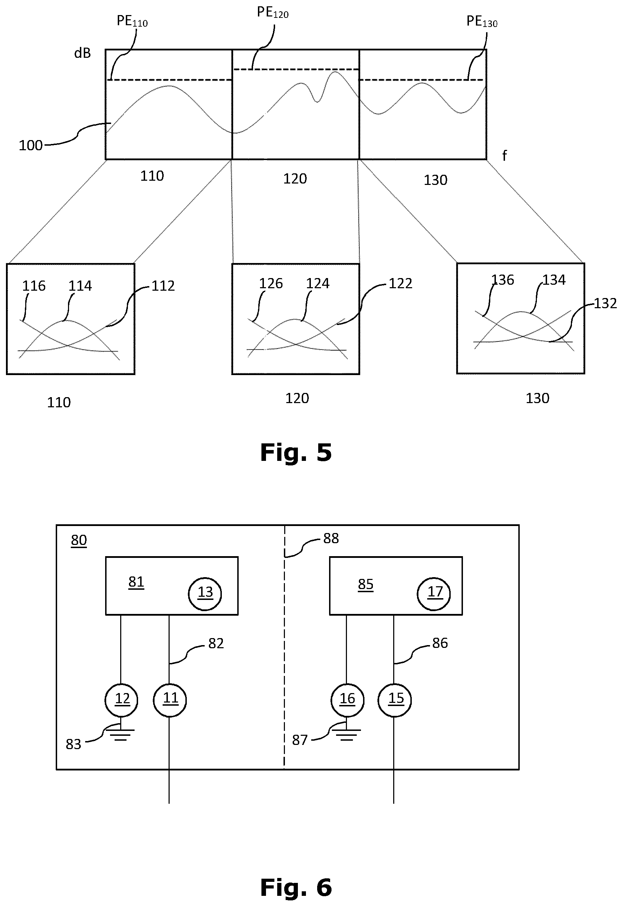

In Figur 5 ist nochmals dargestellt, wie ein erfasstes Frequenzspektrum 100 in Bereiche 110, 120 und 130 unterteilt (beispielsweise mit einer Bereichsfiltervorrichtung) wird und anschließend jeder der Bereiche hochpassgefiltert, bandpassgefiltert und tiefpassgefiltert wird. Mithin ergeben sich die gefilterten Spektren 112, 114, 116, 122, 124, 126, 132, 134, 136.

Für jeden der Bereiche 110, 120 und 130 können sodann vier unterschiedliche Markerkennwerte bestimmt werden. Für den Bereich 110 sind dies PE₁₁₀, PE₁₁₂, PE₁₁₄, PE₁₁₆, wobei PE₁₁₂, PE₁₁₄, und PE₁₁₆ nicht dargestellt sind. Für den Bereich 120 sind dies PE₁₂₀, PE₁₂₂, PE₁₂₄, PE₁₂₆, wobei PE₁₂₂, PE₁₂₄ und PE₁₂₆ nicht dargestellt sind. Für den Bereich 130 sind dies PE₁₃₀, PE₁₃₂, PE₁₃₄, PE₁₃₆, wobei PE₁₃₂, PE₁₃₄ und PE₁₃₆ nicht dargestellt sind. Weiterhin kann für jeden Messpunkt ein solches Frequenzspektrum mit entsprechender Unterteilung und Filterung erfasst bzw. erzeugt werden.

Figur 6 zeigt eine schematische Darstellung einer elektrisch betriebenen Einrichtung 80. Die Einrichtung 80 umfasst zwei Komponenten 81, 85. Diese können beispielsweise Antriebe und/oder Frequenzumrichter sein. Jeder Komponente ist ein Massepunkt 83, 87 sowie eine Versorgungsleitung 82, 86 zugeordnet. An unterschiedlichen Messpunkten sind Spannungssensoren 12, 16, Stromsensoren 11, 15 und H-Feld Sensoren 13, 17 angeordnet. Die beiden Komponenten sind durch eine Entkopplung 88 entkoppelt (z.B. 20 dB Entkopplung).

Mittels der Sensoren kann je ein Frequenzspektrum erfasst werden. Jedes Frequenzspektrum kann dann in Frequenzbereiche unterteilt und tiefpass-, hochpass- und bandpassgefiltert werden, wie dies in Figur 5 dargestellt ist. Für jeden der Messpunkte können dann Markerkennwerte (hier 12 Markerkennwerte) bestimmt werden und mit entsprechenden Referenz-Markerkennwerten vergleichen werden.

Die einzelnen Frequenzspektren (bzw. die Messpunkte) können einer Komponente oder einem Teil einer Komponente zugeordnet werden. Beispielsweise ist das Frequenzspektrum des Sensors 11 der Leitung 82 zugeordnet. Die Messpunkte können verlinkt sein, sodass eine in einem messpunktspezifischen Frequenzspektrum auftretende Störung mit einer tatsächlichen oder stochastischen Degradation einer Komponente verknüpft werden kann. Die Verlinkung ergibt sich durch die konstruktiven Details der Einrichtung 80. Umgekehrt können Störungen von nicht-verlinkten Messpunkten entsprechend unberücksichtigt bleiben.

Die Abweichung der Markerkennwerte bzw. deren Relation zueinander ermöglicht dann die Beurteilung elektromagnetischer Phänomene und die Identifikation von Störungen bzw. deren Ursache.

Beispielsweise kann aus den Markerkennwerten der gefilterten Teil-Frequenzspektren, die auf den Sensoren 11, 12, und 13 beruhen bestimmt werden, ob die Komponente degradiert ist und getauscht werden sollte. Ebenso ist es möglich ein Wartungsintervall anzugeben.

Aus den Markerkennwerten der ungefilterten Teil-Frequenzspektren lässt sich ableiten, ob die Komponente 85 von Komponente 81 gestört und/oder (mit einer gewissen Wahrscheinlichkeit) beschädigt wurde.

Neben der Erstellung eines Wartungskonzepts (Tauschempfehlung, Wartungsintervalle, ...) kann basierend auf den Markerkennwerten bzw. durch einen Vergleich mit Referenz- Markerkennwerten und/oder einem Degradationsmodell ein Condition Monitoring durchgeführt werden, um elektromagnetische Abweichungen in der Einrichtung schnell erkennen zu können. Zudem können die Markerkennwerten und/oder Vergleichsergebnisse zur Erstellung einer Prüfdokumentation für die Reparatur bzw. Instandsetzung der Einrichtung/Komponenten der Einrichtung genutzt werden.

Zudem kann aus den Markerkennwerten und einer Information zu bestehenden (galvanischen) Beeinflussungspfaden eine unterwünschte elektromagnetische Kopplung detektiert und eine entsprechende Warnung ausgegeben werden, sodass eine Entkopplung vorgenommen werden kann.

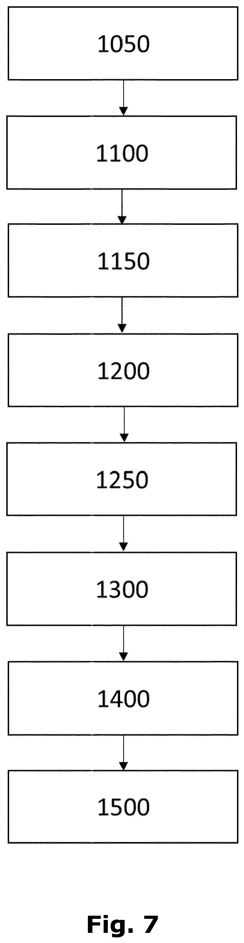

Figur 7 zeigt ein schematisches Ablaufdiagramm eines erfindungsgemäßen Verfahrens 1000. Das Verfahren umfasst:
- Erfassen (optional) 1050 eines elektromagnetischen Frequenzspektrums an zumindest einem Messpunkt einer elektrisch betriebenen Einrichtung.
- Bereitstellen 1100 des erfassten elektromagnetischen Frequenzspektrums 100 an eine Bewertungsfiltervorrichtung oder eine Bereichsfiltervorrichtung
- Unterteilen 1150 des erfassten elektromagnetischen Frequenzspektrums in Teil-Frequenzspektren bzw. Frequenzbereiche
- Filtern 1200 des erfassten elektromagnetischen Frequenzspektrums (bzw. der unterteilten Frequenzbereiche), mittels einer Bewertungsfiltervorrichtung 30, die einen Hochpassfilter 30, einen Bandpassfilter 34 und/oder ein Tiefpassfilter 36 umfasst, und
- Erzeugen 1250 zumindest eines gefilterten Frequenzspektrums bzw. gefilterten Teil-Frequenzspektrums
- Bestimmen 1300 zumindest eines Markerkennwerts PE, welcher Markerkennwert PE ein Maß für den Energiegehalt des gefilterten, elektromagnetischen Frequenzspektrums ist;
- Optional: Detektieren von Peaks im Frequenzspektrum bzw. einem Frequenzbereich
- Vergleichen 1400 des zumindest einen bestimmten Markerkennwerts PE mit einem zugeordneten Referenz-Markerkennwert PE_{ref} oder einem Degradationsmodell, und
- Identifizieren 1500, basierend auf dem Vergleichsergebnis, einer Ursache einer elektromagnetischen Störung.

Anschließend kann die Störung behoben oder ein Intervall bis zur voraussichtlichen Behebung der Störung (z.B. Wartungsintervall) festgelegt werden. Ebenso ist es möglich aus dem Vergleichsergebnis abzuschätzen, ob (und wie) sich die EMV der elektrisch betriebenen Einrichtung verändert hat.

### Bezugszeichenliste

- 1: System
- 10: Sensor
- 11: Stromsensor
- 12: Spannungssensor
- 13: H-Feldsensor
- 15: Stromsensor
- 16: Spannungssensor
- 17: H-Feldsensor
- 20: Bereichsfiltervorrichtung
- 30: Bewertungsfiltervorrichtung
- 32: Hochpassfilter
- 34: Bandpassfilter
- 35: Logarithmischer Verstärker
- 36: Tiefpassfilter
- 37: Treiberstufe
- 40: Marker-Bestimmungsvorrichtung
- 50: Störungsidentifikationsvorrichtung
- 60: Peak-Detektor-Vorrichtung
- 65: A/D-Wandler
- 70: Display
- 80: elektrisch betriebenen Einrichtung
- 81: erste Komponente
- 82: Leitung
- 83: Massepunkt
- 85: zweite Komponente
- 86: Leitung
- 87: Massepunkt
- 88: Entkopplung (z.B. 20 dB)
- 100: Frequenzspektrum
- 101: Einzelwerte
- 102: gefiltertes Frequenzspektrum (z.B. hochpassgefiltert)
- 104: gefiltertes Frequenzspektrum (z.B. bandpassgefiltert)
- 106: gefiltertes Frequenzspektrum (z.B. tiefpassgefiltert)
- 110: Frequenzbereich (z.B. 10 kHz bis 100 kHz)
- 112: gefiltertes Bereichs-Frequenzspektrum
- 114: gefiltertes Bereichs-Frequenzspektrum
- 116: gefiltertes Bereichs-Frequenzspektrum
- 120: Frequenzbereich (z.B. 100 kHz bis 1 MHz)
- 122: gefiltertes Bereichs-Frequenzspektrum
- 124: gefiltertes Bereichs-Frequenzspektrum
- 126: gefiltertes Bereichs-Frequenzspektrum
- 130: Frequenzbereich (z.B. 1 MHz bis 10 MHz)
- 132: gefiltertes Bereichs-Frequenzspektrum
- 134: gefiltertes Bereichs-Frequenzspektrum
- 136: gefiltertes Bereichs-Frequenzspektrum
- 1000: Verfahren
- 1050: Erfassen
- 1100: Bereitstellen
- 1150: Unterteilen
- 1200: Filtern
- 1250: Erzeugen
- 1300: Bestimmen
- 1400: Vergleichen
- 1500: Identifizieren

- PE: Markerkennwert
- PE_{ref}: Referenz-Markerkennwert
- S: Signal
- R: Rauschen

## Patentansprüche

1. System (1) zur Identifikation einer Ursache einer elektromagnetischen Störung in einer elektrisch betriebenen Einrichtung (80), das System (1) umfassend:
zumindest einen Sensor (10), wobei der Sensor (10) zur Erfassung eines elektromagnetischen Frequenzspektrums (100) eingerichtet ist, wobei das erfasste elektromagnetische Frequenzspektrum (100) zumindest zwei Frequenzbereiche (110, 120, 130) umfasst,
eine Bewertungsfiltervorrichtung (30), wobei die Bewertungsfiltervorrichtung (30) einen Hochpassfilter (32), einen Bandpassfilter (34) und/oder ein Tiefpassfilter (36) umfasst, und wobei
die Bewertungsfiltervorrichtung (30) dazu eingerichtet ist, basierend auf dem elektromagnetischen Frequenzspektrum (100), welches der elektrisch betriebenen Einrichtung zugeordnet ist, zumindest ein gefiltertes Frequenzspektrum (102, 104, 106) zu erzeugen, und wobei
die Bewertungsfiltervorrichtung (30) weiter dazu eingerichtet ist, für die zumindest zwei Frequenzbereiche (110, 120, 130) jeweils zumindest ein gefiltertes Bereichs-Frequenzspektrum (112, 114, 116; 122, 124, 126; 132, 134, 136) zu erzeugen;
eine Marker-Bestimmungsvorrichtung (40), wobei die Marker- Bestimmungsvorrichtung (40) dazu eingerichtet ist, zumindest für das gefilterte Frequenzspektrum (102, 104, 106; 112, 114, 116; 122, 124, 126; 132, 134, 136) und das erfasste Frequenzspektrum (100), die Frequenzbereiche (110, 120, 130) und/oder die gefilterten Bereichs-Frequenzspektren (112, 114, 116; 122, 124, 126; 132, 134, 136) je einen Markerkennwert (PE) zu bestimmen, welcher Markerkennwert (PE) ein Maß für den Energiegehalt des gefilterten, elektromagnetischen Frequenzspektrums ist, wobei der Markerkennwert (PE) durch eine logarithmische Addition von Einzelwerten (101) bestimmt wird, welche Einzelwerte (101)
das erfasste Frequenzspektrum (100),
ein gefiltertes Frequenzspektrum (102, 104, 106),
einen Frequenzbereich (110, 120, 130), oder
ein gefiltertes Bereichs-Frequenzspektrum (112, 114, 116; 122, 124, 126; 132, 134, 136) bilden; und
eine Störungsidentifikationsvorrichtung (50), wobei die Störungsidentifikationsvorrichtung (50) dazu eingerichtet ist, den zumindest einen bestimmten Markerkennwert (PE) mit einem zugeordneten Referenz-Markerkennwert (PE_{ref}) zu vergleichen und basierend auf einem Vergleichsergebnis eine Ursache einer elektromagnetischen Störung zu identifizieren.

2. System (1) zur Identifikation einer Ursache einer elektromagnetischen Störung in einer elektrisch betriebenen Einrichtung (80), das System (1) umfassend:
zumindest einen Sensor (10), wobei der Sensor (10) zur Erfassung eines elektromagnetischen Frequenzspektrums (100) eingerichtet ist;
eine Bereichsfiltervorrichtung (20), wobei die Bereichsfiltervorrichtung (20) dazu eingerichtet ist, das erfasste elektromagnetische Frequenzspektrum (100) in zumindest zwei Frequenzbereiche (110, 120, 130) zu unterteilen,
eine Bewertungsfiltervorrichtung (30), wobei die Bewertungsfiltervorrichtung (30) einen Hochpassfilter (32), einen Bandpassfilter (34) und/oder ein Tiefpassfilter (36) umfasst, und wobei
die Bewertungsfiltervorrichtung (30) dazu eingerichtet ist, basierend auf dem elektromagnetischen Frequenzspektrum (100), welches der elektrisch betriebenen Einrichtung zugeordnet ist, zumindest ein gefiltertes Frequenzspektrum (102, 104, 106) zu erzeugen;
eine Marker-Bestimmungsvorrichtung (40), wobei die Marker- Bestimmungsvorrichtung (40) dazu eingerichtet ist, zumindest für das gefilterte Frequenzspektrum (102, 104, 106; 112, 114, 116; 122, 124, 126; 132, 134, 136) einen Markerkennwert (PE) zu bestimmen, welcher Markerkennwert (PE) ein Maß für den Energiegehalt des gefilterten, elektromagnetischen Frequenzspektrums ist, wobei der Markerkennwert (PE) durch eine logarithmische Addition von Einzelwerten (101) bestimmt wird, welche Einzelwerte (101)
das erfasste Frequenzspektrum (100),
ein gefiltertes Frequenzspektrum (102, 104, 106),
einen Frequenzbereich (110, 120, 130), oder
ein gefiltertes Bereichs-Frequenzspektrum (112, 114, 116; 122, 124, 126; 132, 134, 136) bilden; und
eine Störungsidentifikationsvorrichtung (50), wobei die Störungsidentifikationsvorrichtung (50) dazu eingerichtet ist, den zumindest einen bestimmten Markerkennwert (PE) mit einem zugeordneten Referenz-Markerkennwert (PE_{ref}) zu vergleichen und basierend auf einem Vergleichsergebnis eine Ursache einer elektromagnetischen Störung zu identifizieren.

3. System (1) nach Anspruch 1 oder 2, wobei der zumindest eine Sensor (10) optional zumindest einen der folgenden Sensortypen umfasst:
einen H-Feld Sensor (13, 17),
einen Stromsensor (11, 15), und/oder
einen Spannungssensor (12, 16).

4. System (1) nach einem der Ansprüche 1 bis 3, wobei das System mehrere Sensoren (10) umfasst, und wobei die Sensoren (10) unterschiedlichen, definierten Messpunkten der elektrisch betriebenen Einrichtung (80) zuordenbar sind, wobei die Sensoren dazu eingerichtet sind für jeden Messpunkt zumindest ein Frequenzspektrum zu erfassen.

5. System (1) nach einem der vorhergehenden Ansprüche, wobei das erfasste elektromagnetische Frequenzspektrum (100) zumindest einen Frequenzbereich von 5 kHz bis 15 MHz, oder von 10 kHz bis 10 MHz oder von 12 kHz bis 8 MHz umfasst.

6. System (1) nach Anspruch 1 oder 2, wobei die zumindest zwei Frequenzbereiche (110, 120, 130)
einen Frequenzbereich von zumindest 10 kHz bis zumindest 100 kHz, und/oder
einen Frequenzbereich von zumindest 100 kHz bis zumindest 1 MHz, und/oder
einen Frequenzbereich von zumindest 1 MHz bis zumindest 10 MHz umfassen.

7. System (1) nach einem der vorhergehenden Ansprüche, wobei der zumindest eine Sensor (10) in einem ersten Frequenzbereich eine erste Messbandbreite aufweist und in einem zweiten Frequenzbereich eine zweite Messbandbreite, wobei der erste Frequenzbereich unter dem zweiten Frequenzbereich liegt, und wobei die erste Messbandbreite geringer ist als die zweite Messbandbreite.

8. System (1) nach einem der vorhergehenden Ansprüche, wobei das System weiterhin eine Peak-Detektor-Vorrichtung (60) umfasst, wobei die Peak-Detektor-Vorrichtung dazu eingerichtet ist, Peaks, insbesondere zeitlich floatenden Peaks und/oder Burst-Peaks, im erfassten Frequenzspektrum zu ermitteln, wobei
die Störungsidentifikationsvorrichtung (50) dazu eingerichtet ist die ermittelten Peaks bei der Identifikation der Ursache der elektromagnetischen Störung zu berücksichtigen.

9. System (1) nach einem der vorhergehenden Ansprüche, wobei die Störungsidentifikationsvorrichtung (50) weiterhin dazu eingerichtet ist, die bestimmten Markerkennwerte (PE) mit entsprechenden zugeordneten Referenz-Markerkennwerten (PE_{ref}) zu vergleichen und basierend auf dem Vergleich eine Abweichungscharakteristik zu erstellen, wobei
die Störungsidentifikationsvorrichtung (50) dazu eingerichtet ist basierend auf der Abweichungscharakteristik eine Ursache der elektromagnetischen Störung zu identifizieren und/oder eine Störaussendungsprognose zu erstellen.

10. System (1) nach einem der vorhergehenden Ansprüche, wobei die Störungsidentifikationsvorrichtung (50) weiterhin dazu eingerichtet ist, die bestimmten Markerkennwerte (PE) und/oder eine Abweichungscharakteristik mit einem Degradationsmodell, welches der elektrisch betriebenen Einrichtung zugeordnet ist, zu vergleichen und basierend auf dem Vergleich ein empfohlenes Wartungsintervall und/oder eine Komponententauschempfehlung auszugeben.

11. Verfahren (1000) zur Identifikation einer Ursache einer elektromagnetischen Störung in einer elektrisch betriebenen Einrichtung, das Verfahren (1000) umfassend:
Unterteilen (1150) eines elektromagnetischen Frequenzspektrums (100) in zumindest zwei Frequenzbereiche (110, 120, 130);
Filtern (1200) des elektromagnetischen Frequenzspektrums (100) und/oder eines Frequenzbereichs (110, 120, 130), mittels einer Bewertungsfiltervorrichtung (30), die einen Hochpassfilter (32), einen Bandpassfilter (34) und/oder ein Tiefpassfilter (36) umfasst, und Erzeugen (1250) zumindest eines gefilterten Frequenzspektrums (102, 104, 106) und/oder eines gefilterten Bereichs-Frequenzspektrums (112, 114, 116; 122, 124, 126; 132, 134, 136);
Bestimmen (1300) zumindest eines Markerkennwerts (PE), welcher Markerkennwert (PE) ein Maß für den Energiegehalt des gefilterten, elektromagnetischen Frequenzspektrums und/oder eines gefilterten Bereichs-Frequenzspektrums (112, 114, 116; 122, 124, 126; 132, 134, 136) und/oder eines Frequenzbereichs (110, 120, 130) ist, wobei der Markerkennwert (PE) durch eine logarithmische Addition von Einzelwerten (101) bestimmt wird, welche Einzelwerte (101)
das erfasste Frequenzspektrum (100),
ein gefiltertes Frequenzspektrum (102, 104, 106),
einen Frequenzbereich (110, 120, 130), oder
ein gefiltertes Bereichs-Frequenzspektrum (112, 114, 116; 122, 124, 126; 132, 134, 136) bilden;
Vergleichen (1400) des zumindest einen bestimmten Markerkennwerts (PE) mit einem zugeordneten Referenz-Markerkennwert (PE_{ref}) und
Identifizieren (1500), basierend auf dem Vergleichsergebnis, einer Ursache einer elektromagnetischen Störung.

12. Verfahren nach Anspruch 11, weiterhin umfassend das Erfassen (1050) eines elektromagnetischen Frequenzspektrums (100) während des Betriebs der elektrisch betriebenen Einrichtung (80).

13. Computerprogramm, umfassend Anweisungen, die wenn sie von zumindest einem Prozessor ausgeführt werden, den Prozessor dazu veranlassen das Verfahren gemäß Anspruch 11 oder 12 auszuführen..

## Claims

1. System (1) for identifying a cause of an electromagnetic interference in an electrically operated device (80), the system (1) comprising:
at least one sensor (10), wherein the sensor (10) is configured to detect an electromagnetic frequency spectrum (100), wherein the detected electromagnetic frequency spectrum (100) comprises at least two frequency ranges (110, 120, 130),
an evaluation filter device (30), wherein the evaluation filter device (30) comprises a high-pass filter (32), a band-pass filter (34) and/or a low-pass filter (36), and wherein
the evaluation filter device (30) is configured to generate at least one filtered frequency spectrum (102, 104, 106) based on the electromagnetic frequency spectrum (100) which is assigned to the electrically operated device, and wherein
the evaluation filter device (30) is further configured to generate, for each of the at least two frequency ranges (110, 120, 130), at least one filtered range frequency spectrum (112, 114, 116; 122, 124, 126; 132, 134, 136);
a marker determination device (40), wherein the marker determination device (40) is configured to determine, at least for the filtered frequency spectrum (102, 104, 106; 112, 114, 116; 122, 124, 126; 132, 134, 136) and the detected frequency spectrum (100), the frequency ranges (110, 120, 130) and/or the filtered range frequency spectra (112, 114, 116; 122, 124, 126; 132, 134, 136) a marker value (PE) each, which marker value (PE) is a measure of the energy content of the filtered electromagnetic frequency spectrum, wherein the marker value (PE) is determined by a logarithmic addition of individual values (101), which individual values (101) form
the detected frequency spectrum (100),
a filtered frequency spectrum (102, 104, 106),
a frequency range (110, 120, 130), or
a filtered range frequency spectrum (112, 114, 116; 122, 124, 126; 132, 134, 136); and
an interference identification device (50), wherein the interference identification device (50) is configured to compare the at least one specific marker value (PE) with an assigned reference marker value (PE_{ref}) and to identify a cause of an electromagnetic interference based on a comparison result.

2. System (1) for identifying a cause of an electromagnetic interference in an electrically operated device (80), the system (1) comprising:
at least one sensor (10), wherein the sensor (10) is configured to detect an electromagnetic frequency spectrum (100);
a range filter device (20), wherein the range filter device (20) is configured to divide the detected electromagnetic frequency spectrum (100) into at least two frequency ranges (110, 120, 130),
an evaluation filter device (30), wherein the evaluation filter device (30) comprises a high-pass filter (32), a band-pass filter (34) and/or a low-pass filter (36), and wherein
the evaluation filter device (30) is configured to generate at least one filtered frequency spectrum (102, 104, 106) based on the electromagnetic frequency spectrum (100) which is assigned to the electrically operated device;
a marker determination device (40), wherein the marker determination device (40) is configured to determine, at least for the filtered frequency spectrum (102, 104, 106; 112, 114, 116; 122, 124, 126; 132, 134, 136), a marker value (PE), which marker value (PE) is a measure of the energy content of the filtered electromagnetic frequency spectrum, wherein the marker value (PE) is determined by a logarithmic addition of individual values (101), which individual values (101) form
the detected frequency spectrum (100),
a filtered frequency spectrum (102, 104, 106),
a frequency range (110, 120, 130), or
a filtered range frequency spectrum (112, 114, 116; 122, 124, 126; 132, 134, 136); and
an interference identification device (50), wherein the interference identification device (50) is configured to compare the at least one specific marker value (PE) with an assigned reference marker value (PE_{ref}) and to identify a cause of an electromagnetic interference based on a comparison result.

3. System (1) according to claim 1 or 2, wherein the at least one sensor (10) optionally comprises at least one of the following sensor types:
an H-field sensor (13, 17),
a current sensor (11, 15), and/or
a voltage sensor (12, 16).

4. System (1) according to one of claims 1 to 3, wherein the system comprises several sensors (10), and wherein the sensors (10) can be assigned to different, defined measuring points of the electrically operated device (80), wherein the sensors are configured to detect at least one frequency spectrum for each measuring point.

5. System (1) according to one of the preceding claims, wherein the detected electromagnetic frequency spectrum (100) comprises at least one frequency range from 5 kHz to 15 MHz, or from 10 kHz to 10 MHz, or from 12 kHz to 8 MHz.

6. System (1) according to claim 1 or 2, wherein the at least two frequency ranges (110, 120, 130) comprise
a frequency range from at least 10 kHz to at least 100 kHz, and/or
a frequency range from at least 100 kHz to at least 1 MHz, and/or
a frequency range from at least 1 MHz to at least 10 MHz.

7. System (1) according to one of the preceding claims, wherein the at least one sensor (10) has a first measurement bandwidth in a first frequency range and a second measurement bandwidth in a second frequency range, wherein the first frequency range is below the second frequency range, and wherein the first measurement bandwidth is lower than the second measurement bandwidth.

8. System (1) according to one of the preceding claims, wherein the system further comprises a peak detector device (60), wherein the peak detector device is configured to detect peaks, in particular time-floating peaks and/or burst peaks, in the detected frequency spectrum, wherein
the interference identification device (50) is configured to take the detected peaks into account when identifying the cause of the electromagnetic interference.

9. System (1) according to one of the preceding claims, wherein the interference identification device (50) is further configured to compare the determined marker values (PE) with corresponding assigned reference marker values (PE_{ref}) and to create a deviation characteristic based on the comparison, wherein
the interference identification device (50) is configured to identify a cause of the electromagnetic interference and/or to create an interference emission forecast based on the deviation characteristic.

10. System (1) according to one of the preceding claims, wherein the interference identification device (50) is further configured to compare the determined marker values (PE) and/or a deviation characteristic with a degradation model which is assigned to the electrically operated device, and to output a recommended maintenance interval and/or a component replacement recommendation based on the comparison.

11. Method (1000) for identifying a cause of an electromagnetic interference in an electrically operated device, the method (1000) comprising:
dividing (1150) an electromagnetic frequency spectrum (100) into at least two frequency ranges (110, 120, 130);
filtering (1200) the electromagnetic frequency spectrum (100) and/or a frequency range (110, 120, 130) by means of an evaluation filter device (30) comprising a high-pass filter (32), a band-pass filter (34) and/or a low-pass filter (36), and generating (1250) at least one filtered frequency spectrum (102, 104, 106) and/or a filtered range frequency spectrum (112, 114, 116; 122, 124, 126; 132, 134, 136);
determining (1300) at least one marker value (PE), which marker value (PE) is a measure of the energy content of the filtered electromagnetic frequency spectrum and/or of a filtered range frequency spectrum (112, 114, 116; 122, 124, 126; 132, 134, 136) and/or of a frequency range (110, 120, 130), wherein the marker value (PE) is determined by a logarithmic addition of individual values (101), which individual values (101) form
the detected frequency spectrum (100),
a filtered frequency spectrum (102, 104, 106),
a frequency range (110, 120, 130), or
a filtered range frequency spectrum (112, 114, 116; 122, 124, 126; 132, 134, 136);
comparing (1400) the at least one specific marker value (PE) with an assigned reference marker value (PE_{ref}) and
identifying (1500) a cause of an electromagnetic interference based on the comparison result.

12. Method according to claim 11, further comprising the detection (1050) of an electromagnetic frequency spectrum (100) during the operation of the electrically operated device (80).

13. Computer program comprising instructions which, when executed by at least one processor, cause the processor to execute the method according to claim 11 or 12.

## Revendications

1. Système (1) d'identification de la cause d'une perturbation électromagnétique dans un dispositif à fonctionnement électrique (80), le système (1) comprenant :
au moins un capteur (10), ledit capteur (10) étant conçu pour détecter un spectre de fréquences électromagnétiques (100), lequel spectre de fréquences électromagnétiques (100) détecté comprend au moins deux plages de fréquences (110, 120, 130) ;
un dispositif de filtrage d'évaluation (30), ledit dispositif de filtrage d'évaluation (30) comprenant un filtre passe-haut (32), un filtre passe-bande (34) et/ou un filtre passe-bas (36), étant entendu que
le dispositif de filtrage d'évaluation (30) est conçu pour générer au moins un spectre de fréquences filtré (102, 104, 106) compte tenu du spectre de fréquences électromagnétiques (100) associé au dispositif à fonctionnement électrique, et que
le dispositif de filtrage d'évaluation (30) est en outre conçu pour générer au moins un spectre de fréquences de plage filtrée (112, 114, 116 ; 122, 124, 126 ; 132, 134, 136) respectif pour les au moins deux plages de fréquences (110, 120, 130) ;
un dispositif de détermination de marqueur (40), ledit dispositif de détermination de marqueur (40) étant conçu pour déterminer une valeur caractéristique de marqueur (PE) respective, au moins pour le spectre de fréquences filtré (102, 104, 106 ; 112, 114, 116 ; 122, 124, 126 ; 132, 134, 136) et le spectre de fréquences (100) détecté, les plages de fréquences (110, 120, 130) et/ou les spectres de fréquences de plage filtrée (112, 114, 116 ; 122, 124, 126 ; 132, 134, 136), laquelle valeur caractéristique de marqueur (PE) est une mesure du contenu énergétique du spectre de fréquences électromagnétiques filtré, ladite valeur caractéristique de marqueur (PE) étant déterminée par une addition logarithmique de valeurs individuelles (101), lesquelles valeurs individuelles (101) forment
le spectre de fréquences (100) détecté,
un spectre de fréquences filtré (102, 104, 106),
une plage de fréquences (110, 120, 130), ou
un spectre de fréquences de plage filtrée (112, 114, 116 ; 122, 124, 126 ; 132, 134, 136) ; et
un dispositif d'identification de perturbation (50), ledit dispositif d'identification de perturbation (50) étant conçu pour comparer l'au moins une valeur caractéristique de marqueur (PE) déterminée avec une valeur caractéristique de marqueur de référence (PE_{ref}) associée et pour identifier la cause d'une perturbation électromagnétique compte tenu du résultat de comparaison.

2. Système (1) d'identification de la cause d'une perturbation électromagnétique dans un dispositif à fonctionnement électrique (80), le système (1) comprenant :
au moins un capteur (10), ledit capteur (10) étant conçu pour détecter un spectre de fréquences électromagnétiques (100) ;
un dispositif de filtrage de plage (20), ledit dispositif de filtrage de plage (20) étant conçu pour diviser le spectre de fréquences électromagnétiques (100) détecté en au moins deux plages de fréquences (110, 120, 130) ;
un dispositif de filtrage d'évaluation (30), ledit dispositif de filtrage d'évaluation (30) comprenant un filtre passe-haut (32), un filtre passe-bande (34) et/ou un filtre passe-bas (36), et étant entendu que
le dispositif de filtrage d'évaluation (30) est conçu pour générer au moins un spectre de fréquences filtré (102, 104, 106) compte tenu du spectre de fréquences électromagnétiques (100) associé au dispositif à fonctionnement électrique ;
un dispositif de détermination de marqueur (40), conçu pour déterminer une valeur caractéristique de marqueur (PE) au moins pour le spectre de fréquences filtré (102, 104, 106 ; 112, 114, 116 ; 122, 124, 126 ; 132, 134, 136), laquelle valeur caractéristique de marqueur (PE) est une mesure du contenu énergétique du spectre de fréquences électromagnétiques filtré, ladite valeur caractéristique de marqueur (PE) étant déterminée par une addition logarithmique de valeurs individuelles (101), lesquelles valeurs individuelles (101) forment
le spectre de fréquence (100) détecté,
un spectre de fréquences filtré (102, 104, 106),
une plage de fréquences (110, 120, 130), ou
un spectre de fréquences de plage filtrée (112, 114, 116 ; 122, 124, 126 ; 132, 134, 136) ; et
un dispositif d'identification de perturbation (50), ledit dispositif d'identification de perturbation (50) étant conçu pour comparer l'au moins une valeur caractéristique de marqueur (PE) déterminée avec une valeur caractéristique de marqueur de référence (PE_{ref}) associée et pour identifier la cause d'une perturbation électromagnétique compte tenu du résultat de comparaison.

3. Système (1) selon la revendication 1 ou 2, dans lequel l'au moins un capteur (10) comprend éventuellement au moins un des types de capteur suivants :
un capteur de champ H (13, 17),
un capteur d'intensité (11, 15), et/ou
un capteur de tension (12, 16).

4. Système (1) selon l'une des revendications 1 à 3, ledit système comprenant plusieurs capteurs (10), et dans lequel les capteurs (10) peuvent être associés à différents points de mesure définis du dispositif à fonctionnement électrique (80), lesdits capteurs étant conçus pour détecter au moins un spectre de fréquences pour chaque point de mesure.

5. Système (1) selon l'une des revendications précédentes, dans lequel le spectre de fréquences électromagnétiques (100) détecté comprend au moins une plage de fréquences de 5 kHz à 15 MHz, ou de 10 kHz à 10 MHz ou de 12 kHz à 8 MHz.

6. Système (1) selon la revendication 1 ou 2, dans lequel les au moins deux plages de fréquences (110, 120, 130) comprennent :
une plage de fréquences d'au moins 10 kHz à au moins 100 kHz, et/ou
une plage de fréquences d'au moins 100 kHz à au moins 1 MHz, et/ou
une plage de fréquences d'au moins 1 MHz à au moins 10 MHz.

7. Système (1) selon l'une des revendications précédentes, dans lequel l'au moins un capteur (10) présente une première bande passante de mesure dans une première plage de fréquences et une deuxième bande passante de mesure dans une deuxième plage de fréquences, ladite première plage de fréquences étant inférieure à ladite deuxième plage de fréquences, et ladite première bande passante de mesure étant inférieure à ladite deuxième bande passante de mesure.

8. Système (1) selon l'une des revendications précédentes, dans lequel le système comprend en outre un dispositif de détection de crête (60), lequel est conçu pour détecter les crêtes dans le spectre de fréquences détecté, notamment les crêtes flottantes dans le temps et/ou les crêtes en rafale,
ledit dispositif d'identification de perturbation (50) étant conçu pour prendre en compte les crêtes détectées lors de l'identification de la cause de la perturbation électromagnétique.

9. Système (1) selon l'une des revendications précédentes, dans lequel le dispositif d'identification de perturbation (50) est en outre conçu pour comparer les valeurs caractéristiques de marqueur (PE) déterminées avec des valeurs caractéristiques de marqueur de référence (PE_{ref}) associées correspondantes et pour créer une caractéristique d'écart compte tenu de cette comparaison,
ledit dispositif d'identification de perturbation (50) étant conçu pour identifier une cause de la perturbation électromagnétique compte tenu de la caractéristique d'écart et/ou pour effectuer un pronostic d'émission d'interférences.

10. Système (1) selon l'une des revendications précédentes, dans lequel le dispositif d'identification de perturbation (50) est en outre conçu pour comparer les valeurs caractéristiques de marqueur (PE) déterminées et/ou une caractéristique d'écart avec un modèle de dégradation associé au dispositif à fonctionnement électrique et pour émettre un intervalle de maintenance recommandé et/ou une recommandation de remplacement de composant compte tenu de la comparaison.

11. Procédé (1000) d'identification de la cause d'une perturbation électromagnétique dans un dispositif à fonctionnement électrique, le procédé (1000) comprenant :
la division (1150) d'un spectre de fréquences électromagnétiques (100) en au moins deux plages de fréquences (110, 120, 130) ;
le filtrage (1200) du spectre de fréquences électromagnétiques (100) et/ou d'une plage de fréquences (110, 120, 130) au moyen d'un dispositif de filtrage d'évaluation (30) comprenant un filtre passe-haut (32), un filtre passe-bande (34) et/ou un filtre passe-bas (36), et la génération (1250) d'au moins un spectre de fréquences filtré (102, 104, 106) et/ou d'un spectre de fréquences de plage filtrée (112, 114, 116 ; 122, 124, 126 ; 132, 134, 136) ;
la détermination (1300) d'au moins une valeur caractéristique de marqueur (PE), laquelle valeur caractéristique de marqueur (PE) est une mesure du contenu énergétique du spectre de fréquences électromagnétiques filtré et/ou d'une plage de spectre de fréquences filtrée (112, 114, 116 ; 122, 124, 126 ; 132, 134, 136) et/ou d'une plage de fréquences (110, 120, 130), ladite valeur caractéristique de marqueur (PE) étant déterminée par une addition logarithmique de valeurs individuelles (101), lesquelles valeurs individuelles (101) forment
le spectre de fréquences (100) détecté,
un spectre de fréquences filtré (102, 104, 106),
une plage de fréquences (110, 120, 130), ou
un spectre de fréquences de plage filtrée (112, 114, 116 ; 122, 124, 126 ; 132, 134, 136) ;
la comparaison (1400) de l'au moins une valeur caractéristique de marqueur (PE) déterminée avec une valeur caractéristique de marqueur de référence (PE_{ref}) associée ; et
l'identification (1500), compte tenu du résultat de comparaison, de la cause d'une perturbation électromagnétique.

12. Procédé selon la revendication 11, comprenant en outre la détection (1050) d'un spectre de fréquences électromagnétiques (100) pendant le fonctionnement du dispositif à fonctionnement électrique (80).

13. Programme informatique comprenant des instructions qui, lorsqu'elles sont exécutées par au moins un processeur, amènent ledit processeur à exécuter le procédé selon la revendication 11 ou 12.
